# EUROPEAN PATENT SPECIFICATION

(11) **EP 4 418 356 B1**
(45) Date of publication and mention of the grant of the patent: **23.09.2026**
(21) Application number: 22897531.4
(22) Date of filing: 27.10.2022
(51) Int. Cl.: H01M 4/04, H01M 4/36, H01M 4/38, H01M 4/133, H01M 4/134, H01M 4/1393, H01M 4/1395, H01M 4/62, H01M 10/0525, H01M 4/587, C23C 16/24, C23C 16/26, C23C 16/44, H01M 4/02

(54) **SILICON-CARBON NEGATIVE ELECTRODE MATERIAL OF LITHIUM-ION BATTERY, PREPARATION METHOD THEREFOR AND APPLICATION THEREOF**
NEGATIVES SILICIUM-KOHLENSTOFF-ELEKTRODENMATERIAL EINER LITHIUM-IONEN-BATTERIE, HERSTELLUNGSVERFAHREN DAFÜR UND ANWENDUNG DAVON
MATÉRIAU D'ÉLECTRODE NÉGATIVE AU SILICIUM-CARBONE DE BATTERIE AU LITHIUM-ION, SON PROCÉDÉ DE PRÉPARATION ET SON APPLICATION

(30) Priority: 25.11.2021 CN 202111411879
(43) Date of publication of application: 21.08.2024
(73) Proprietor: Hunan Zhongke Shinzoom Co., Ltd., Ningxiang Changsha, Hunan 410000 (CN)
(72) Inventor: WANG, Zhiyong, Ningxiang Changsha, Hunan 410000 (CN)
(74) Representative: Santarelli
(86) International application number: PCT/CN2022/128002
(87) International publication number: WO 2023/093448

(56) References cited:
- CN-A- 107 431 189
- CN-A- 110 311 125
- CN-A- 110 311 125
- CN-A- 110 635 128
- CN-A- 111 180 713
- CN-A- 112 133 915
- CN-A- 112 768 668
- CN-A- 113 078 318
- KR-A- 20180 039 925

## Description

### TECHNICAL FIELD

This application belongs to the field of a negative electrode material for a lithium-ion battery, and particularly to a silicon-carbon negative electrode material for a lithium-ion battery, a method for preparing the same, and usage thereof.

### BACKGROUND

Lithium-ion batteries have broad application prospects and are in great demand in fields such as mobile electronic devices, electric vehicles, and large-scale energy storage. Negative electrode materials used in traditional lithium-ion battery systems are mainly graphitic materials. However, a theoretical specific capacity of the graphitic materials is relatively low, only 372mAh·g⁻¹, which is difficult to meet a high-energy-density requirement of new lithium-ion batteries. Therefore, it is crucial to develop a new high-capacity negative electrode material for lithium-ion batteries.

Silicon is regarded as a new generation of lithium-ion battery negative electrode material and has attracted widespread attention and research interest because of its extremely high theoretical specific capacity (4200mAh/g) and a suitable potential for lithium deintercalation. However, shortcomings of silicon such as low first Coulombic efficiency and poor cycling performance caused by extremely large volume change rate (>300%) of silicon during charge and discharge have become main obstacles to commercial application of silicon-based lithium-ion battery negative electrode materials.

In a traditional method for preparing nano-silicon through chemical vapor deposition (CVD), a silicon source after decomposition easily agglomerates on a material of carbon substrate to form micron-level granular or linear products, resulting in loss of a unique advantage of nano-silicon. Moreover, when a silicon-carbon negative electrode material is prepared with nano-silicon directly, it is difficult for nano-silicon to be evenly dispersed throughout the system, resulting in an excessive expansion rate of an electrode piece during charge and discharge, and further degrading material performances.

CN 104103821 A provides a method for preparing a silicon-carbon negative electrode material. The method includes: 1) placing a catalyst in a CVD reaction chamber; 2) obtaining a silicon-carbon negative electrode material precursor by: heating the CVD reaction chamber, injecting a reaction gas source and a carrier gas into the CVD reaction chamber, and leading Si-Siox generated during the CVD reaction to pass through a carbon matrix which is rotated dynamically and subjected to carboxylation treatment; and 3) obtaining the silicon-carbon negative electrode material by: performing organic pyrolytic carbon coating treatment on the precursor and calcining in a non-oxidizing atmosphere. In this way, nano-silicon with a high specific capacity can be prepared, but the prepared silicon fails to be fully and evenly distributed on all surface interfaces of the carbon matrix, resulting in potential dangers such as deterioration of cycling performance and excessive volume expansion rate of the material.

CN 1903793 provides a carbon-silicon composite material and a method for preparing the same, and usage thereof. The carbon-silicon composite material includes a silicon matrix, and carbon nanotubes or nanocarbon fibers grown the silicon matrix. The carbon nanotubes or nanocarbon fibers have a straight geometric appearance, or a curved or spiral geometric appearance. The carbon-silicon composite material may be prepared in many ways. A catalyst may be loaded onto a silicon material, or the catalyst and silicon particles are mixed or alloyed, and then the carbon nanotubes or nanocarbon fibers are deposited with a CVD method. Although the surface-grown carbon nanotubes or nanocarbon fibers provided in this way have a large specific surface area and a large porosity, silicon particles fail to be evenly distributed on the surface, and thus, the problem of volume expansion of the silicon particles during cycling fails to be solved.

CN 109449388 A provides a method for preparing a carbon-silicon negative electrode material for a lithium-ion battery. The method includes: (1) obtaining porous carbon by: carbonizing starch and a catalyst under a vacuum condition after the starch and the catalyst are mixed evenly, and then performing washing, drying, grinding, and sieving; (2) adding the porous carbon obtained in operation (1) for mixing after graphite aqueous solution and nano-silicon aqueous solution are mixed, and then drying, grinding, and sieving a mixture; and (3) obtaining the carbon-silicon negative electrode material for the lithium-ion battery by: dissolving an organic carbon source into water, adding a product obtained in operation (2) and concentrated sulfuric acid sequentially, performing insulating, washing, and drying on a mixture liquid after the mixture liquid is stirred, and then performing vacuum carbonization. Such method adopts graphite as a buffer for volume expansion of silicon particles. However, a theoretical specific capacity of graphite materials is relatively low, and it is difficult to meet the high-energy-density requirement of new lithium-ion batteries. Moreover, this method is complicated and is not conducive to industrial production.

Therefore, how to provide a method for preparing an industrialized silicon-based silicon-carbon composite material that can alleviate a problem of volume expansion of silicon during cycling and reduce a production difficulty has become a problem to be solved in this field. CN113078318A relates to the field of lithium battery anode materials, specifically to a three-dimensional porous silicon-carbon composite material. The three-dimensional porous silicon-carbon composite material comprises a three-dimensional porous skeleton, a filling layer, and a coating layer. The three-dimensional porous skeleton is a three-dimensional porous carbon skeleton. The filling layer includes silicon particles and conductive carbon, formed by uniformly dispersing the silicon particles within the conductive carbon. The coating layer is a carbon coating. The invention provides a three-dimensional porous silicon-carbon composite material with long cycle life and low expansion, as well as its preparation method and applications.
CN111180713A relates to a silicon-carbon anode material for lithium-ion batteries and its preparation method. The anode material adopts a core-shell structure, where the core consists of nano-silicon, pyrolytic carbon, and single-walled carbon nanotubes, while the shell is a carbon coating formed by vapor-phase deposition. The particle size of the nano-silicon ranges from 5 to 100 nm; the softening point of the pyrolytic carbon is below 300°C, with a residual carbon content exceeding 40%; the diameter of the single-walled carbon nanotubes is between 5 and 20 nm, preferably 5 to 10 nm, and the tube length is 30 to 500 nm, preferably 30 to 100 nm. The thickness of the carbon coating is 10 to 200 nm. The preparation method includes: (1) homogeneous composite of pyrolytic carbon precursor and single-walled carbon nanotubes; (2) CVD deposition of nano-silicon onto pyrolytic carbon; (3) mechanical shaping; and (4) carbon coating. The silicon-carbon anode material prepared by this invention features a simple process, excellent performance, and environmental friendliness.
CN110311125A pertains to the field of lithium-ion battery technology, specifically involving a silicon-carbon anode material for lithium-ion batteries and its preparation method. The anode material features a core-shell structure, with the core consisting of porous graphite and nano-silicon. The graphite's pores are formed through strong alkali etching, while the nano-silicon is grown within the graphite pores via CVD deposition. The shell comprises an organic pyrolytic carbon layer. The porous graphite exhibits a porosity of 10-60%; the nano-silicon has a median particle size of 20-100 nm; and the carbon coating layer ranges in thickness from 0.1 to 1 µm. Compared to existing technologies, the silicon-carbon anode material prepared by this invention utilizes porous graphite to preemptively accommodate the volume expansion of nano-silicon, significantly mitigating such expansion. Additionally, it enhances ion and electron transport rates, delivers excellent electrochemical performance, ensures structural stability, and features a simple preparation process with low costs, making it suitable for industrial production.
CN110635128A relates to a negative electrode composite material for lithium-ion batteries, consisting of a composite graphite matrix, carbon coated nano silicon, conductive carbon, amorphous carbon first coating layer, and polymer carbon second coating layer. The present invention first places nano silicon in a reaction furnace, introduces protective gas, and then introduces cracking gas for cracking reaction to obtain carbon coated nano silicon; Then, carbon coated nano silicon is added to the composite graphite solution, and the graphite/nano silicon/conductive carbon precursor is prepared by drying and granulation; Then, a first amorphous carbon coating layer and a second polymer carbon coating layer are wrapped around its surface. The preparation process of the present invention is simple, the negative electrode composite material has a high specific capacity, high initial charge and discharge efficiency, and excellent cycling stability.

### SUMMARY

The invention is set out in the appended set of claims. The following is a summary of the solutions of the DETAILED DESCRIPTION in the disclosure. This summary is not intended to limit the protection scope of the appended claims.

In view of the above deficiencies of the related art, the disclosure provides a silicon-carbon negative electrode material for a lithium-ion battery, a method for preparing the same, and usage thereof. The method can achieve even vapor deposition of nano-silicon particles by adopting a porous carbon-based film material, thereby effectively alleviating a problem of volume expansion of silicon during cycling. Moreover, polarization of the material can be improved effectively through carbon deposition, thereby effectively improving electrochemical performances of the silicon-carbon negative electrode material.

In order to solve the above technical problems, the disclosure adopts the following technical solutions.

In a first aspect, the disclosure provides a method for preparing a silicon-carbon negative electrode material for a lithium-ion battery. The method includes: (1) forming an oxygen-free environment inside a reactor by fixing a porous carbon-based film material inside the reactor and injecting an inert gas to replace air inside the reactor; (2) obtaining a silicon-carbon negative electrode material precursor by heating and insulating the reactor where the oxygen-free environment is formed in operation (1) and injecting a silane gas for a chemical vapor deposition (CVD) reaction; and (3) obtaining the silicon-carbon negative electrode material for the lithium-ion battery by performing carbon coating, crushing, secondary coating, and carbonization on the silicon-carbon negative electrode material precursor obtained in operation (2).

In the method for preparing the silicon-carbon negative electrode material for the lithium-ion battery provided in the disclosure, the porous carbon-based film material is used as a substrate, which can achieve even vapor deposition of nano-silicon particles, thereby effectively alleviating the problem of volume expansion of silicon during cycling.

Generally, deposition of the silane gas is not easy to operate. In the disclosure, a pressure difference before and after injecting of the silane gas into the porous carbon-based film material make the silane gas deposit in gaps of the porous carbon-based film material, and the porous carbon-based film material can directionally guide deposition and adsorption of silane molecules inside the gaps by controlling a gas flow direction. As such, when the silane gas passes through the gaps of the porous carbon-based film material, part of the silane gas can be adsorbed inside the gaps effectively.

The reactor is not specifically limited in the disclosure, as long as the reactor can ensure the gas flow to pass through in a directional manner and is a heatable device.

Optionally, the porous carbon-based film material in operation (1) includes any one of carbon paper, a carbon nanotube film, or a graphene film.

According to the invention, the porous carbon-based film material in operation (1) has a thickness of 100 µm to 500 µm, such as 100 µm, 150 µm, 200 µm, 250 µm, 300 µm, 350 µm, 400 µm, 450 µm, or 500 µm, but the thickness of the porous carbon-based film material is not limited to the listed values, other unlisted values within the numerical range are also applicable.

If the thickness of the porous carbon-based film material of the disclosure is too large, there will be a large difference in the amount of silane deposited on front and rear surfaces of the porous carbon-based film material, resulting in uneven deposition. Conversely, if the thickness is too small, when the silane gas passes through at a certain flow rate, the porous carbon-based film material may be penetrated, so that the silane gas fails to be deposited in the porous carbon-based film, resulting in material waste.

According to the invention, the porous carbon-based film material in operation (1) has a tortuosity of 1.5 to 5, such as 1.5, 2, 2.5, 3, 3.5, 4, 4.5, or 5, but the tortuosity of the porous carbon-based film material is not limited to the listed values, other unlisted values within the numerical range are also applicable.

Optionally, a temperature after heating up ranges from 600°C to 800°C in operation (2), such as 600°C, 620°C, 640°C, 660°C, 680°C, 700°C, 720°C, 740°C, 760°C, 780°C, or 800°C, but the temperature after heating up is not limited to the listed values, other unlisted values within the numerical range are also applicable.

Optionally, a time of the insulating in operation (2) ranges from 0.5h to 2h, such as 0.5h, 0.8h, 1h, 1.2h, 1.4h, 1.6h, 1.8h, or 2h, but the time of the insulating is not limited to the listed values, other unlisted values within the numerical range are also applicable.

According to the invention, an angle between a position of the porous carbon-based film material in operation (1) and a flow direction of the silane gas in operation (2) ranges from 60° to 120°, such as 60°, 70°, 80°, 90°, 100°, 110°, or 120°, but the angle is not limited to the listed values, other unlisted values within the numerical range are also applicable.

Optionally, the angle between the position of the porous carbon-based film material in operation (1) and the flow direction of the silane gas in operation (2) is 90°.

In the disclosure, the porous carbon-based film material is placed at a certain angle with the flow direction of the silane gas, so that the silane gas can pass through the porous carbon-based film material, which facilitates deposition of silane inside gaps of the porous carbon-based film material.

Optionally, a gas flow rate of the silane gas in operation (2) ranges from 0.1L/min to 2L/min, such as 0.1L/min, 0.5L/min, 1L/min, 1.5L/min, or 2L/min, but the gas flow rate is not limited to the listed values, other unlisted values within the numerical range are also applicable.

In the disclosure, if the gas flow rate of the silane gas is too high, a residence time of the silane gas inside the film material will be reduced, as a result, effective adsorption fails to be achieved. Moreover, an excessive gas flow rate will make the film material of a certain strength unable to withstand or even rupture. In addition, since the film material has a certain degree of tortuosity, which has a certain hindering effect on the gas, if the gas flow rate is too small, the silane gas will not be able to pass through the film and only stay on a surface of the film material.

Optionally, a flow time of the silane gas in operation (2) ranges from 2h to 5h, such as 2h, 2.5h, 3h, 3.5h, 4h, 4.5h, or 5h, but the flow time is not limited to the listed values, and other unlisted values within the numerical range are also applicable.

Optionally, the carbon coating in operation (3) is performed in an inert gas atmosphere.

Optionally, the inert gas includes helium and/or argon.

Optionally, a temperature of the carbon coating in operation (3) ranges from 800°C to 1200°C, such as 800°C, 850°C, 900°C, 950°C, 1000°C, 1050°C, 1100°C, 1150°C, or 1200°C, but the temperature of the carbon coating is not limited to the listed values, other unlisted values within the numerical range are also applicable.

Optionally, a coating time of the carbon coating in operation (3) ranges from 2h to 6h, such as 2h, 2.5h, 3h, 3.5h, 4h, 4.5h, 5h, 5.5h, or 6h, but the coating time is not limited to the listed values, other unlisted values within the numerical range are also applicable.

Optionally, a carbon-containing gas source during the carbon coating in operation (3) includes any one or a combination of at least two of methane, ethane, propane, ethylene, propylene, or acetylene. Exemplary combinations include, but not limited to, a combination of methane and ethane, a combination of methane and propane, a combination of methane and ethylene, a combination of methane and propylene, a combination of methane and acetylene, a combination of methane, ethane, and acetylene, or a combination of methane, ethane, propane, ethylene, and acetylene.

Optionally, particles obtained after crushing in operation (3) each have an average particle size D50 ranging from 5 µm to 20 µm, such as 5 µm, 8 µm, 10 µm, 12 µm, 14 µm, 16 µm, 18 µm, or 20 µm, but the average particle size is not limited to the listed values, other unlisted values within the numerical range are also applicable.

Optionally, a coating material for the secondary coating in operation (3) includes an organic carbon source.

Optionally, the organic carbon source includes any one or a combination of at least two of asphalt, tar, or phenolic resin. Exemplary combinations include, but not limited to, a combination of asphalt and tar, a combination of asphalt and phenolic resin, a combination of tar and phenolic resin, or a combination of asphalt, tar, and phenolic resin.

Optionally, a coating ratio of the secondary coating in operation (3) ranges from 5% to 20%, such as 5%, 8%, 10%, 12%, 14%, 16%, 18%, or 20%, but the coating ratio is not limited to the listed values, other unlisted values within the numerical range are also applicable.

Optionally, a temperature of the carbonization in operation (3) ranges from 800°C to 1200°C, such as 800°C, 850°C, 900°C, 950°C, 1000°C, 1050°C, 1100°C, 1150°C, or 1200°C, but the temperature of the carbonization is not limited to the listed values, other unlisted values within the numerical range are also applicable.

Optionally, a time of the carbonization in operation (3) ranges from 3h to 10h, such as 3h, 4h, 5h, 6h, 7h, 8h, 9h, or 10h, but the time of the carbonization is not limited to the listed values, other unlisted values within the numerical range are also applicable.

As a preferred technical solution of the method described in the first aspect of the disclosure, the method includes: (1) forming the oxygen-free environment inside the reactor by fixing the porous carbon-based film material inside the reactor and injecting the inert gas to replace the air inside the reactor, where the porous carbon-based film material has a thickness of 100 µm to 500 µm and a tortuosity of 1.5 to 5; (2) obtaining the silicon-carbon negative electrode material precursor by: heating up the reactor where the oxygen-free environment is formed in operation (1) to 600°C to 800°C, performing insulating for 0.5h to 2h, injecting the silane gas for 2h to 5h at a gas flow rate of 0.1L/min to 2L/min for the CVD reaction, and forming nano-silicon particles, where an angle between a flow direction of the silane gas and a position of the porous carbon-based film material in operation (1) ranges from 60° to 120°; and (3) obtaining the silicon-carbon negative electrode material for the lithium-ion battery by: performing carbon coating on the silicon-carbon negative electrode material precursor obtained in operation (2) in an inert gas atmosphere at a temperature of 800°C to 1200°C for 2h to 6h with a carbon-containing gas source, then performing crushing on the silicon-carbon negative electrode material precursor to obtain particles with an average particle size D50 of 5 µm to 20 µm, performing secondary coating with a coating material, and performing carbonization at 800°C to 1200°C for 3h to 10h, wherein a coating ratio of the secondary coating ranges from 5% to 20%.

In a second aspect, the disclosure provides a silicon-carbon negative electrode material for a lithium-ion battery. The silicon-carbon negative electrode material is obtained through the method described in the first aspect.

In a third aspect, the disclosure provides usage of a silicon-carbon negative electrode material for a lithium-ion battery prepared through the method described in the first aspect. The silicon-carbon negative electrode material is used as a negative electrode material of the lithium-ion battery.

Each of the numerical ranges described in the disclosure not only includes the values listed above, but also includes any unlisted value within said numerical range. For the sake of space limitation and conciseness, the disclosure does not exhaustively list all specific values in each of the numerical ranges.

Compared with the existing technology, the disclosure has the following advantageous effects.

The method for preparing the silicon-carbon negative electrode material for the lithium-ion battery of the disclosure can achieve even vapor deposition of nano-silicon particles by adopting the porous carbon-based film material, thereby effectively alleviating the problem of volume expansion of silicon during cycling. Moreover, polarization of the material can be improved effectively through carbon deposition, thereby effectively improving electrochemical performances of the silicon-carbon negative electrode material.

Other aspects will become apparent after reading and understanding the DETAILED DESCRIPTION.

### DETAILED DESCRIPTION

Hereinafter, technical solutions of the disclosure will be further depicted through exemplary embodiments. Those skilled in the art should understand that embodiments described below are to help understand the disclosure and should not be construed as limiting the disclosure.

### First embodiment

This embodiment provides a silicon-carbon negative electrode material for a lithium-ion battery. The method includes: (1) forming an oxygen-free environment inside a reactor by fixing carbon paper inside the reactor and injecting helium to replace air inside the reactor, where a porous carbon-based film material has a thickness of 250 µm and a tortuosity of 3; (2) obtaining a silicon-carbon negative electrode material precursor by: heating up the reactor where the oxygen-free environment is formed in operation (1) to 700°C, performing insulating for 1.2h, and injecting a silane gas for 3.5h at a gas flow rate of 0.5L/min for a chemical vapor deposition (CVD) reaction, where an angle between a flow direction of the silane gas and a position of the porous carbon-based film material in operation (1) is 90°; and (3) obtaining the silicon-carbon negative electrode material for the lithium-ion battery by: performing carbon coating on the silicon-carbon negative electrode material precursor obtained in operation (2) in helium atmosphere at a temperature of 1000°C for 4h with methane, then performing crushing on the silicon-carbon negative electrode material precursor to obtain particles with an average particle size D50 of 10 µm, performing secondary coating with pitch, and performing carbonization at 1000°C, where a coating ratio of the secondary coating is 10%.

### Second embodiment

This embodiment provides a silicon-carbon negative electrode material for a lithium-ion battery. The method includes: (1) forming an oxygen-free environment inside a reactor by fixing carbon paper inside the reactor and injecting helium to replace air inside the reactor, where a porous carbon-based film material has a thickness of 100 µm and a tortuosity of 1.5; (2) obtaining a silicon-carbon negative electrode material precursor by: heating up the reactor where the oxygen-free environment is formed in operation (1) to 600°C, performing insulating for 2h, and injecting a silane gas for 5h at a gas flow rate of 0.1L/min for a CVD reaction, where an angle between a flow direction of the silane gas and a position of the carbon paper in operation (1) is 60°; and (3) obtaining the silicon-carbon negative electrode material for the lithium-ion battery by: performing carbon coating on the silicon-carbon negative electrode material precursor obtained in operation (2) in helium atmosphere at a temperature of 1200°C for 2h with acetylene, then performing crushing on the silicon-carbon negative electrode material precursor to obtain particles with an average particle size D50 of 20 µm, performing secondary coating with tar, and performing carbonization at 1200°C for 3h, where a coating ratio of the secondary coating is 8%.

### Third embodiment

This embodiment provides a silicon-carbon negative electrode material for a lithium-ion battery. The method includes: (1) forming an oxygen-free environment inside a reactor by fixing carbon paper inside the reactor and injecting helium to replace air inside the reactor, where a porous carbon-based film material has a thickness of 500 µm and a tortuosity of 5; (2) obtaining a silicon-carbon negative electrode material precursor by: heating up the reactor where the oxygen-free environment is formed in operation (1) to 800°C, performing insulating for 0.5h, and injecting a silane gas for 2h at a gas flow rate of 2L/min for a CVD reaction, where an angle between a flow direction of the silane gas and a position of the carbon paper in operation (1) is 120°; and (3) obtaining the silicon-carbon negative electrode material for the lithium-ion battery by: performing carbon coating on the silicon-carbon negative electrode material precursor obtained in operation (2) in helium atmosphere at a temperature of 800°C for 6h with a mixed gas of ethane and propane, then performing crushing on the silicon-carbon negative electrode material precursor to obtain particles with an average particle size D50 of 5 µm, performing secondary coating with phenolic resin, and performing carbonization at 800°C for 10h, where a coating ratio of the secondary coating is 12%.

### Fourth embodiment

This embodiment provides a silicon-carbon negative electrode material for a lithium-ion battery. The method includes: (1) forming an oxygen-free environment inside a reactor by fixing carbon paper inside the reactor and injecting helium to replace air inside the reactor, where a porous carbon-based film material has a thickness of 300 µm and a tortuosity of 2.7; (2) obtaining a silicon-carbon negative electrode material precursor by: heating up the reactor where the oxygen-free environment is formed in operation (1) to 680°C, performing insulating for 1.6h, and injecting a silane gas for 4h at a gas flow rate of 0.8L/min for a CVD reaction, where an angle between a flow direction of the silane gas and a position of the carbon paper in operation (1) is 85°; and (3) obtaining the silicon-carbon negative electrode material for the lithium-ion battery by: performing carbon coating on the silicon-carbon negative electrode material precursor obtained in operation (2) in helium atmosphere at a temperature of 1050°C for 3.5h with a mixed gas of methane and acetylene, then performing crushing on the silicon-carbon negative electrode material precursor to obtain particles with an average particle size D50 of 15 µm, performing secondary coating with pitch, and performing carbonization at 1050°C for 8h, where a coating ratio of the secondary coating is 16%.

### Fifth embodiment

This embodiment provides a silicon-carbon negative electrode material for a lithium-ion battery. Other operations and parameters involved in the method are consistent with those of the first embodiment, except that in operation (1), the carbon paper is replaced with a carbon nanotube film.

### Sixth embodiment

This embodiment provides a silicon-carbon negative electrode material for a lithium-ion battery. Other operations and parameters involved in the method are consistent with those of the first embodiment, except that in operation (1), the carbon paper is replaced with a graphene film.

### Seventh embodiment

This embodiment provides a silicon-carbon negative electrode material for a lithium-ion battery. Other operations and parameters involved in the method are consistent with those of the first embodiment, except that in operation (1), the thickness of the carbon paper is changed to 80 µm.

### Eighth embodiment

This embodiment provides a silicon-carbon negative electrode material for a lithium-ion battery. Other operations and parameters involved in the method are consistent with those of the first embodiment, except that in operation (1), the thickness of the carbon paper is changed to 600 µm.

### Ninth embodiment

This embodiment provides a silicon-carbon negative electrode material for a lithium-ion battery. Other operations and parameters involved in the method are consistent with those of the first embodiment, except that the angle between the flow direction of the silane gas in operation (2) and the position of the carbon paper in operation (1) is changed to 20°.

### Tenth embodiment

This embodiment provides a silicon-carbon negative electrode material for a lithium-ion battery. Other operations and parameters involved in the method are consistent with those of the first embodiment, except that the angle between the flow direction of the silane gas in operation (2) and the position of the carbon paper in operation (1) is changed to 0°.

### Eleventh embodiment

This embodiment provides a silicon-carbon negative electrode material for a lithium-ion battery. Other operations and parameters involved in the method are consistent with those of the first embodiment, except that in operation (2), heating up to 500°C.

### Twelfth embodiment

This embodiment provides a silicon-carbon negative electrode material for a lithium-ion battery. Other operations and parameters involved in the method are consistent with those of the first embodiment, except that in operation (2), heating up to 900°C.

### First comparative embodiment

This comparative embodiment provides a silicon-carbon negative electrode material for a lithium-ion battery. The method includes: preparing silicon particles by: evacuating a CVD equipment, injecting a mixed gas of silane and argon into the CVD equipment, and performing heating at 800°C for 7h; and preparing the silicon-carbon negative electrode material by: injecting a mixed gas of acetylene and argon into the CVD equipment, performing heating at 800°C for 1h, and preparing a carbon coating layer on surfaces of the silicon particles.

### Second comparative embodiment

This comparative embodiment provides a silicon-carbon negative electrode material for a lithium-ion battery. The method includes: (a) obtaining a powder material by: mixing nano-silicon dispersion, conductive additive, and a coating material, dispersing and stirring for 2h, and perform spray drying; (b) obtaining a silicon-carbon negative electrode material precursor by: heating up to 1000°C at a heating rate of 3°C/min, performing carbonization heat treatment on the powder material obtained in operation (a) for 6h, and then crushing; and (c) obtaining the silicon-carbon negative electrode material for the lithium-ion battery by compounding a graphite material with the silicon-carbon negative electrode material precursor obtained in operation (b).

The silicon-carbon negative electrode materials for the lithium-ion battery prepared through the first to twelfth embodiments and the first to second comparative embodiments are applied to lithium-ion batteries, and electrochemical performances of these lithium-ion batteries are tested. The tests are conducted on Wuhan Blue Electric CT2001A battery tester, where a voltage ranges from 0.005V to 1.5V, a rate for capacity test is 0.05C/0.05C, and a rate for cycle test is 0.5C/0.5C. The specific test results are shown in Table 1.

The cycle test of a battery refers to test of a full battery made by matching a ternary positive electrode material with a negative electrode material of 420mAh/g prepared through mixing of a material and a commercial graphite material. The ternary material (e.g., LiNi_{1/3}Co_{1/3}Mn_{1/3}O₂) is used as a positive electrode, LiPF6 (e.g., solvent: EC+DEC, a volume ratio of 1:1, a concentration of 1.3mol/l) is used as electrolyte, celegard2400 is used as a separator, to prepare a soft-pack battery.

Full-charge rebound test: first, after the capacity of a soft pack battery is set, disassemble the soft pack battery, and the thickness of a negative electrode plate of the battery is tested to be *D1*; then, the soft-pack battery is fully charged for 100 times, and disassemble the soft-pack battery, and the thickness of the negative electrode plate of the battery is tested to be *D2;* finally, calculate the full-charge rebound rate (*D2-D1*)/*D1.*

**Table 1**

| | Discharge specific capacity (mAh/g) | First cycle efficiency (%) | Full-charge rebound rate (%) | retention rate after 500 cycles (%) |
|---|---|---|---|---|
| First embodiment | 1670 | 91.3 | 31.2 | 93.6 |
| Second embodiment | 1610 | 91.5 | 32.1 | 93.1 |
| Third embodiment | 1530 | 92.3 | 30.1 | 92.8 |
| Fourth embodiment | 1580 | 91.7 | 30.6 | 92.9 |
| Fifth embodiment | 1690 | 91.0 | 32.3 | 93.5 |
| Sixth embodiment | 1720 | 90.8 | 32.4 | 93.7 |
| Seventh embodiment | 1215 | 92.3 | 28.1 | 93.2 |
| Eighth embodiment | 1123 | 90.6 | 34.8 | 90.1 |
| Ninth embodiment | 521 | 92.3 | 27.6 | 94.1 |
| Tenth embodiment | 392 | 92.5 | 26.3 | 93.8 |
| Eleventh embodiment | 1320 | 92.1 | 30.1 | 93.0 |
| Twelfths embodiment | 1420 | 91.6 | 31.5 | 92.7 |
| First comparative embodiment | 2530 | 88.2 | 43.3 | 72 |
| Second comparative embodiment | 420 | 89.3 | 38.2 | 85.7 |

As can be seen from Table 1, the silicon-carbon negative electrode material obtained in the disclosure has a high capacity more than 1530mAh/g, and has a high first cycle efficiency and an excellent cycling performance. Different carbon nanofilm substrates can effectively achieve nano-silicon deposition, thereby ensuring improvement of the cycling performance of the battery. By comparison, it is found that when the thickness of the film material is too small, the film material will be damaged during reaction, so that an adsorption film of the silane gas fails to be formed effectively, resulting in a reduction in a capacity of the material. However, when the thickness of the film material is too large, a gas passing rate will be low, resulting in uneven deposition phenomenon with much silane gas deposited at the front but little silane gas deposited at the back. In addition, too much deposition at the front will also lead to aggregation of silicon nanoparticles, resulting in a decrease in the cycling performance of the battery. By comparison, it is found that when the film material is fixed at a low angle, the silane gas will selectively bypass the film material, so that less deposition on the film material, as a result, preparing of nano-silicon particles on the film material fails, and preparing of the high-capacity silicon-carbon negative electrode material fails to be realized. A relatively high or low pyrolysis reaction temperature is not conducive to deposition of nano-silicon in the material, resulting in a decrease in a capacity of the material.

In sum, the method for preparing the silicon-carbon negative electrode material for the lithium-ion battery provided in the disclosure can achieve even vapor deposition of nano-silicon particles with the porous carbon-based film material, thereby effectively alleviating the problem of volume expansion of silicon during cycling. Moreover, polarization of the material can be improved effectively through carbon deposition, thereby effectively improving electrochemical performances of the silicon-carbon negative electrode material.

The Applicant declares that, while the objectives, technical solutions, and advantageous effects of the disclosure have been described in detail in connection with the exemplary embodiments, it is to be understood that the above is only specific embodiments of the disclosure and is not intended to limit the disclosure, the scope of which is defined by the appended claims.

## Claims

1. A method for preparing a silicon-carbon negative electrode material for a lithium-ion battery, comprising:
(1) forming an oxygen-free environment inside a reactor by fixing a porous carbon-based film material inside the reactor and injecting an inert gas to replace air inside the reactor, wherein the porous carbon-based film material has a thickness of 100 µm to 500 µm; and the porous carbon-based film material has a tortuosity of 1.5 to 5;
(2) obtaining a silicon-carbon negative electrode material precursor by: heating and insulating the reactor where the oxygen-free environment is formed in operation (1), and injecting a silane gas into the porous carbon-based film material for a chemical vapor deposition, CVD, reaction, wherein an angle between a position of the porous carbon-based film material in operation (1) and a flow direction of the silane gas in operation (2) ranges from 60° to 120°; and
(3) obtaining the silicon-carbon negative electrode material for the lithium-ion battery by: performing carbon coating on the silicon-carbon negative electrode material precursor obtained in operation (2) with a carbon-containing gas source, obtaining particles by performing crushing on the silicon-carbon negative electrode material precursor subjected to the carbon coating, performing secondary coating on the particles with a coating material, and performing carbonization, wherein the coating material for the secondary coating comprises an organic carbon source.

2. The method of claim 1, wherein the porous carbon-based film material in operation (1) comprises any one of carbon paper, a carbon nanotube film, or a graphene film.

3. The method of claim 1 or 2, wherein heating up to 600°C to 800°C in operation (2); and a time of the insulating in operation (2) ranges from 0.5h to 2h.

4. The method of any of claims 1 to 3, wherein
the angle between the position of the porous carbon-based film material in operation (1) and the flow direction of the silane gas in operation (2) is 90°;
a gas flow rate of the silane gas in operation (2) ranges from 0.1L/min to 2L/min; and
a flow time of the silane gas in operation (2) ranges from 2h to 5h.

5. The method of any of claims 1 to 4, wherein the carbon coating in operation (3) is performed in an inert gas atmosphere;
the inert gas comprises at least one of helium or argon;
a temperature of the carbon coating in operation (3) ranges from 800°C to 1200°C;
a coating time of the carbon coating in operation (3) ranges from 2h to 6h; and
the carbon-containing gas source in a carbon coating process in operation (3) comprises any one or a combination of at least two of methane, ethane, propane, ethylene, propylene, or acetylene.

6. The method of any of claims 1 to 5, wherein the particles obtained after crushing in operation (3) each have an average particle size D50 ranging from 5 µm to 20 µm.

7. The method of any of claims 1 to 6, wherein
the organic carbon source comprises any one or a combination of at least two of pitch, tar, or phenolic resin;
a coating ratio of the secondary coating in operation (3) ranges from 5% to 20%;
a temperature of the carbonization in operation (3) ranges from 800°C to 1200°C; and
a time of the carbonization in operation (3) ranges from 3h to 10h.

8. The method of any of claims 1 to 7, wherein
(1) forming the oxygen-free environment inside the reactor by fixing the porous carbon-based film material inside the reactor and injecting the inert gas to replace the air inside the reactor, wherein the porous carbon-based film material has a thickness of 100 µm to 500 µm and a tortuosity of 1.5 to 5;
(2) obtaining the silicon-carbon negative electrode material precursor by: heating up the reactor where the oxygen-free environment is formed in operation (1) to 600°C to 800°C, performing insulating for 0.5h to 2h, and injecting the silane gas for 2h to 5h at a gas flow rate of 0.1L/min to 2L/min for the CVD reaction, wherein an angle between a flow direction of the silane gas and a position of the porous carbon-based film material in operation (1) ranges from 60° to 120°; and
(3) obtaining the silicon-carbon negative electrode material for the lithium-ion battery by: performing carbon coating on the silicon-carbon negative electrode material precursor obtained in operation (2) in an inert gas atmosphere at a temperature of 800°C to 1200°C for 2h to 6h with the carbon-containing gas source, then performing crushing on the silicon-carbon negative electrode material precursor to obtain particles with an average particle size D50 of 5 µm to 20 µm, performing secondary coating with the coating material, and performing carbonization at 800°C to 1200°C for 3h to 10h, wherein a coating ratio of the secondary coating ranges from 5% to 20%.

9. A silicon-carbon negative electrode material for a lithium-ion battery obtainable according to the method of any of claims 1-8, wherein the silicon-carbon negative electrode material is prepared by using a porous carbon-based film material and a silane gas, the porous carbon-based film material has a thickness of 100 µm to 500 µm and a tortuosity of 1.5 to 5, and an angle between a position of the porous carbon-based film material and a flow direction of the silane gas ranges from 60° to 120°.

10. A lithium-ion battery, containing a silicon-carbon negative electrode material, according to claim 9, which is prepared by using a porous carbon-based film material and a silane gas, the porous carbon-based film material has a thickness of 100 µm to 500 µm and a tortuosity of 1.5 to 5, and an angle between a position of the porous carbon-based film material and a flow direction of the silane gas ranges from 60° to 120°.

## Patentansprüche

1. Verfahren zum Herstellen eines Silizium-Kohlenstoff-Negativelektrodenmaterials für eine Lithium-Ionen-Batterie, umfassend:
(1) Bilden einer sauerstofffreien Umgebung innerhalb eines Reaktors durch Fixieren eines porösen kohlenstoffbasierten Folienmaterials innerhalb des Reaktors und Einleiten eines Inertgases, um Luft innerhalb des Reaktors zu ersetzen, wobei das poröse kohlenstoffbasierte Folienmaterial eine Dicke von 100 µm bis 500 µm aufweist; und das poröse kohlenstoffbasierte Folienmaterial eine Krümmung von 1,5 bis 5 aufweist;
(2) Erhalten eines Silizium-Kohlenstoff-Negativelektrodenmaterialvorläufers durch: Erwärmen und Isolieren des Reaktors, in dem die sauerstofffreie Umgebung im Betrieb (1) gebildet wird, und Einleiten eines Silangases in das poröse kohlenstoffbasierte Folienmaterial für eine chemische Dampfabscheidungs-, CVD,-Reaktion, wobei ein Winkel zwischen einer Position des porösen kohlenstoffbasierten Folienmaterials im Betrieb (1) und einer Strömungsrichtung des Silangases im Betrieb (2) zwischen 60° und 120° liegt; und
(3) Erhalten des Silizium-Kohlenstoff-Negativelektrodenmaterials für die Lithium-Ionen-Batterie durch: Durchführen einer Kohlenstoffbeschichtung auf dem im Betrieb (2) erhaltenen Silizium-Kohlenstoff-Negativelektrodenmaterialvorläufer mit einer kohlenstoffhaltigen Gasquelle, Erhalten von Partikeln durch Durchführen eines Zerkleinerns des Silizium-Kohlenstoff-Negativelektrodenmaterialvorläufers, der der Kohlenstoffbeschichtung unterzogen wurde, Durchführen einer Sekundärbeschichtung der Partikeln mit einem Beschichtungsmaterial und Durchführen einer Karbonisierung, wobei das Beschichtungsmaterial für die Sekundärbeschichtung eine organische Kohlenstoffquelle umfasst.

2. Verfahren nach Anspruch 1, wobei das poröse kohlenstoffbasierte Folienmaterial im Betrieb (1) eines von einem Kohlepapier, einer Kohlenstoff-Nanoröhrenfolie oder einer Graphenfolie umfasst.

3. Verfahren nach Anspruch 1 oder 2, wobei das Erwärmen auf 600 °C bis 800 °C im Betrieb (2) erfolgt; und
eine Dauer des Isolierens im Betrieb (2) zwischen 0,5 h und 2 h liegt.

4. Verfahren nach einem der Ansprüche 1 bis 3, wobei
der Winkel zwischen der Position des porösen kohlenstoffbasierten Folienmaterials im Betrieb (1) und der Strömungsrichtung des Silangases im Betrieb (2) 90° beträgt;
eine Gasdurchflussrate des Silangases im Betrieb (2) zwischen 0,1 l/min und 2 l/min liegt; und
eine Durchflusszeit des Silangases im Betrieb (2) zwischen 2 h und 5 h liegt.

5. Verfahren nach einem der Ansprüche 1 bis 4, wobei die Kohlenstoffbeschichtung im Betrieb (3) in einer Inertgasatmosphäre durchgeführt wird;
das Inertgas mindestens eines aus Helium oder Argon umfasst;
eine Temperatur der Kohlenstoffbeschichtung im Betrieb (3) zwischen 800 °C und 1200 °C liegt;
eine Beschichtungszeit der Kohlenstoffbeschichtung im Betrieb (3) zwischen 2 h und 6 h liegt; und
die kohlenstoffhaltige Gasquelle in einem in Betrieb (3) befindlichen Kohlenstoffbeschichtungsverfahren eine beliebiges von Methan, Ethan, Propan, Ethylen, Propylen oder Acetylen oder eine Kombination aus mindestens zwei von diesen umfasst.

6. Verfahren nach einem der Ansprüche 1 bis 5, wobei die nach dem Zerkleinern im Betrieb (3) erhaltenen Partikel jeweils eine durchschnittliche Partikelgröße D50 von 5 µm bis 20 µm aufweisen.

7. Verfahren nach einem der Ansprüche 1 bis 6, wobei
die organische Kohlenstoffquelle eines von Pech, Teer oder Phenolharz oder oder eine Kombination aus mindestens zwei von diesen umfasst;
ein Beschichtungsverhältnis der Sekundärbeschichtung im Betrieb (3) zwischen 5 % und 20 % liegt;
eine Temperatur der Karbonisierung im Betrieb (3) zwischen 800 °C und 1200 °C liegt; und
eine Dauer der Karbonisierung im Betrieb (3) zwischen 3 h und 10 h liegt.

8. Verfahren nach einem der Ansprüche 1 bis 7, wobei
(1) Bilden der sauerstofffreien Umgebung innerhalb des Reaktors durch Fixieren des porösen kohlenstoffbasierten Folienmaterials innerhalb des Reaktors und Einleiten des Inertgases, um die Luft innerhalb des Reaktors zu ersetzen, wobei das poröse kohlenstoffbasierte Folienmaterial eine Dicke von 100 µm bis 500 µm und eine Krümmung von 1,5 bis 5 aufweist;
(2) Erhalten des Silizium-Kohlenstoff-Negativelektrodenmaterialvorläufers durch: Erwärmen des Reaktors, in dem die sauerstofffreie Umgebung im Betrieb (1) gebildet wird, auf 600 °C bis 800 °C, Isolieren für 0,5 h bis 2 h und Einleiten des Silangases für 2 h bis 5 h bei einer Gasdurchflussrate von 0,1 l/min bis 2 l/min für die CVD-Reaktion, wobei ein Winkel zwischen einer Strömungsrichtung des Silangases und einer Position des porösen kohlenstoffbasierten Folienmaterials im Betrieb (1) zwischen 60° und 120° liegt; und
(3) Erhalten des Silizium-Kohlenstoff-Negativelektrodenmaterials für die Lithium-Ionen-Batterie durch: Durchführen einer Kohlenstoffbeschichtung des im Betrieb (2) erhaltenen Silizium-Kohlenstoff-Negativelektrodenmaterialvorläufers in einer Inertgasatmosphäre bei einer Temperatur zwischen 800 °C und 1200 °C für 2 h bis 6 h mit der kohlenstoffhaltigen Gasquelle, anschließend Durchführen eines Zerkleinerns des Silizium-Kohlenstoff-Negativelektrodenmaterialvorläufers, um Partikel mit einer durchschnittlichen Partikelgröße D50 von 5 µm bis 20 µm zu erhalten, Durchführen einer Sekundärbeschichtung mit dem Beschichtungsmaterial und Durchführen einer Karbonisierung bei 800 °C bis 1200 °C für 3 h bis 10 h, wobei ein Beschichtungsverhältnis der Sekundärbeschichtung zwischen 5 % und 20 % liegt.

9. Silizium-Kohlenstoff-Negativelektrodenmaterial für eine Lithium-Ionen-Batterie, das gemäß dem Verfahren nach einem der Ansprüche 1 bis 8 erhalten werden kann, wobei das Silizium-Kohlenstoff-Negativelektrodenmaterial durch Verwendung eines porösen kohlenstoffbasierten Folienmaterials und eines Silangases hergestellt wird, das poröse kohlenstoffbasierte Folienmaterial eine Dicke von 100 µm bis 500 µm und eine Krümmung von 1,5 bis 5 aufweist und ein Winkel zwischen einer Position des porösen kohlenstoffbasierten Folienmaterials und einer Strömungsrichtung des Silangases zwischen 60° und 120° liegt.

10. Lithium-Ionen-Batterie, die ein Silizium-Kohlenstoff-Negativelektrodenmaterial nach Anspruch 9 enthält, das unter Verwendung eines porösen kohlenstoffbasierten Folienmaterials und eines Silangases hergestellt wird, wobei das poröse kohlenstoffbasierte Folienmaterial eine Dicke von 100 µm bis 500 µm und eine Krümmung von 1,5 bis 5 aufweist und ein Winkel zwischen einer Position des porösen kohlenstoffbasierten Folienmaterials und einer Strömungsrichtung des Silangases zwischen 60° und 120° liegt.

## Revendications

1. Procédé de préparation d'un matériau d'électrode négative au silicium-carbone pour une batterie lithium-ion, comportant :
(1) la formation d'un environnement exempt d'oxygène à l'intérieur d'un réacteur par fixation d'un matériau pelliculaire poreux à base de carbone à l'intérieur du réacteur et injection d'un gaz inerte pour remplacer l'air à l'intérieur du réacteur, dans lequel le matériau pelliculaire poreux à base de carbone présente une épaisseur de 100 µm à 500 µm ; et le matériau pelliculaire poreux à base de carbone présente une tortuosité de 1,5 à 5 ;
(2) l'obtention d'un précurseur de matériau d'électrode négative au silicium-carbone par : chauffage et isolation du réacteur où l'environnement exempt d'oxygène est formé à l'opération (1), et injection d'un gaz silane dans le matériau pelliculaire poreux à base de carbone en vue d'une réaction de dépôt chimique en phase vapeur, CVD, dans lequel un angle entre une position du matériau pelliculaire poreux à base de carbone à l'opération (1) et une direction d'écoulement du gaz silane à l'opération (2) va de 60° à 120° ; et
(3) l'obtention du matériau d'électrode négative au silicium-carbone pour la batterie lithium-ion par : application d'un revêtement en carbone sur le précurseur de matériau d'électrode négative au silicium-carbone obtenu à l'opération (2) avec une source de gaz contenant du carbone, obtention de particules en réalisant un concassage sur le précurseur de matériau d'électrode négative au silicium-carbone soumis à l'application de revêtement en carbone, application d'un revêtement secondaire sur les particules avec un matériau de revêtement, et réalisation d'une carbonisation, dans lequel le matériau de revêtement pour le revêtement secondaire comporte une source de carbone organique.

2. Procédé selon la revendication 1, dans lequel le matériau pelliculaire poreux à base de carbone à l'opération (1) comporte l'un quelconque parmi du papier carbone, un film de nanotubes de carbone ou un film de graphène.

3. Procédé selon la revendication 1 ou 2, dans lequel le chauffage atteint jusqu'à 600 °C à 800 °C à l'opération (2) ; et
un temps de l'isolation à l'opération (2) va de 0,5 h à 2 h.

4. Procédé selon l'une quelconque des revendications 1 à 3, dans lequel
l'angle entre la position du matériau pelliculaire poreux à base de carbone à l'opération (1) et la direction d'écoulement du gaz silane à l'opération (2) est de 90° ;
un débit de gaz du gaz silane à l'opération (2) va de 0,1 L/min à 2 L/min ; et
un temps d'écoulement du gaz silane à l'opération (2) va de 2 h à 5 h.

5. Procédé selon l'une quelconque des revendications 1 à 4, dans lequel le revêtement en carbone à l'opération (3) est appliqué dans une atmosphère de gaz inerte ;
le gaz inerte comporte au moins l'un parmi l'hélium ou l'argon ;
une température du revêtement en carbone à l'opération (3) va de 800 °C à 1 200 °C ;
un temps d'application du revêtement en carbone à l'opération (3) va de 2 h à 6 h ; et
la source de gaz contenant du carbone au cours d'un processus d'application de revêtement en carbone à l'opération (3) comporte l'un quelconque ou une combinaison d'au moins deux parmi du méthane, de l'éthane, du propane, de l'éthylène, du propylène ou de l'acétylène.

6. Procédé selon l'une quelconque des revendications 1 à 5, dans lequel les particules obtenues après concassage à l'opération (3) présentent chacune une taille moyenne de particule D50 allant de 5 µm à 20 µm.

7. Procédé selon l'une quelconque des revendications 1 à 6, dans lequel
la source de carbone organique comporte l'un quelconque ou une combinaison d'au moins deux parmi du brai, du goudron ou de la résine phénolique ;
un rapport de revêtement du revêtement secondaire à l'opération (3) va de 5 % à 20 % ;
une température de la carbonisation à l'opération (3) va de 800 °C à 1 200 °C ; et
un temps de la carbonisation à l'opération (3) va de 3 h à 10 h.

8. Procédé selon l'une quelconque des revendications 1 à 7, dans lequel
(1) la formation de l'environnement exempt d'oxygène à l'intérieur du réacteur par fixation du matériau pelliculaire poreux à base de carbone à l'intérieur du réacteur et injection du gaz inerte pour remplacer l'air à l'intérieur du réacteur, dans lequel le matériau pelliculaire poreux à base de carbone présente une épaisseur de 100 µm à 500 µm et une tortuosité de 1,5 à 5 ;
(2) l'obtention du précurseur de matériau d'électrode négative au silicium-carbone par : chauffage du réacteur où l'environnement exempt d'oxygène est formé à l'opération (1) à 600 °C à 800 °C, isolation assurée pendant 0,5 h à 2 h, et injection du gaz silane pendant 2 h à 5 h à un débit de gaz de 0,1 L/min à 2 L/min en vue de la réaction CVD, dans lequel un angle entre une direction d'écoulement du gaz silane et une position du matériau pelliculaire poreux à base de carbone à l'opération (1) va de 60° à 120° ; et
(3) l'obtention du matériau d'électrode négative au silicium-carbone pour la batterie lithium-ion par : application d'un revêtement en carbone sur le précurseur de matériau d'électrode négative au silicium-carbone obtenu à l'opération (2) dans une atmosphère de gaz inerte à une température de 800 °C à 1 200 °C pendant 2 h à 6 h avec la source de gaz contenant du carbone, puis réalisation d'un concassage sur le précurseur de matériau d'électrode négative au silicium-carbone pour obtenir des particules d'une taille moyenne de particule D50 de 5 µm à 20 µm, application d'un revêtement secondaire avec le matériau de revêtement, et réalisation d'une carbonisation à 800 °C à 1 200 °C pendant 3 h à 10 h, dans lequel un rapport de revêtement du revêtement secondaire va de 5 % à 20 %.

9. Matériau d'électrode négative au silicium-carbone pour une batterie lithium-ion obtenu selon le procédé de l'une quelconque des revendications 1 à 8, dans lequel le matériau d'électrode négative au silicium-carbone est préparé en utilisant un matériau pelliculaire poreux à base de carbone et un gaz silane, le matériau pelliculaire poreux à base de carbone présente une épaisseur de 100 µm à 500 µm et une tortuosité de 1,5 à 5, et un angle entre une position du matériau pelliculaire poreux à base de carbone et une direction d'écoulement du gaz silane va de 60° à 120°.

10. Batterie lithium-ion, contenant un matériau d'électrode négative au silicium-carbone, selon la revendication 9, qui est préparé en utilisant un matériau pelliculaire poreux à base de carbone et un gaz silane, le matériau pelliculaire poreux à base de carbone présente une épaisseur de 100 µm à 500 µm et une tortuosité de 1,5 à 5, et un angle entre une position du matériau pelliculaire poreux à base de carbone et une direction d'écoulement du gaz silane va de 60° à 120°.
